Europäisches Patentamt

European Patent Office

Office européen des brevets

(19)

(11) Veröffentlichungsnummer: **0 226 572 B1**

(12) # EUROPÄISCHE PATENTSCHRIFT

(45) Veröffentlichungstag der Patentschrift:
06.11.91 Patentblatt 91/45

(51) Int. Cl.$^5$: **H01L 41/08**

(21) Anmeldenummer: **86890337.8**

(22) Anmeldetag: **15.12.86**

(54) Messwertaufnehmer mit einem flexiblen piezoelektrischen Film als Messelement.

(30) Priorität: **20.12.85 AT 3718/85**

(43) Veröffentlichungstag der Anmeldung:
**24.06.87 Patentblatt 87/26**

(45) Bekanntmachung des Hinweises auf die
Patenterteilung:
**06.11.91 Patentblatt 91/45**

(84) Benannte Vertragsstaaten:
**DE ES FR GB IT SE**

(56) Entgegenhaltungen:
**EP-A- 0 143 046**
**FR-A- 2 498 405**
**US-A- 4 193 010**

(73) Patentinhaber: **AVL Gesellschaft für
Verbrennungskraftmaschinen und
Messtechnik mbH.Prof.Dr.Dr.h.c. Hans List
Kleiststrasse 48
A-8020 Graz (AT)**

(72) Erfinder: **Engel, Günter, Dipl.-Ing. Dr.
Dorfstrasse 58
A-8430 Leitring (AT)**
Erfinder: **Krempl, Peter W., Dr.
Kainbach 211
A-8047 Graz/Ragnitz (AT)**
Erfinder: **Harms, Klaus-Christoph, Dr.
Attemsgasse 11
A-8010 Graz (AT)**
Erfinder: **List, Helmut, Dipl.-Ing.
Bogengasse 36
A-8010 Graz (AT)**

(74) Vertreter: **Krause, Walter, Dr. Dipl.-Ing. et al
Postfach 200 Singerstrasse 8
A-1010 Wien (AT)**

# Beschreibung

Die Erfindung bezieht sich auf einen flexiblen Meßwertaufnehmer mit einem Meßelement zur Messung mechanischer Größen an Hohlkörpern, insbesondere des Druckverlaufes in Rohren, welches Meßelement einen flexiblen piezoelektrischen Film beinhaltet, wobei die gegenüberliegenden Oberflächen des Meßelementes mit elektrisch leitenden Kontaktflächen eine feste Verbindung bilden und über Leitungen mit einer Anziege- und Auswerteeinrichtung verbindbar sind.

Durch die AT-PS 375 466 wurde ein solcher Meßwertaufnehmer bekannt, bei dem ein aus einem piezoelektrischen Film, dessen beide Seiten mit einer elektrisch leitenden Schicht versehen sind, bestehendes Meßelement auf ein flexibles Kunststoffband aufgebracht oder zwischen zwei solcher Kundststoffbänder eingeklebt ist. Für solche Meßwertaufnehmer werden entsprechend vorbehandelte Polyvinyliden-Fluorid-Folien als piezoelektrischer Film verwendet. Solche Meßwertaufnehmer eignen sich sehr gut für die Erfassung z.B. von Druckänderungen in Rohren, wobei ein solcher Meßwertaufnehmer einfach z.B. mittels einer Klammer auf das zu überwachende Rohr aufgeklemmt wird.

Weiters wurde durch die US-PS 4 541 284 ein Meßwertaufnehmer bekannt, bei dem die Elektroden nur an ihren Rändern mit einer piezoelektrischen Schichte verklebt sind und die piezoelektrische Schichte lediglich durch eine Fassung des Meßelementes mit einer Trägerschichte in Kontakt gehalten wird. Bei einem solchen Meßwertaufnehmer kann es bei ungenauer Montage zu Fehlmessungen kommen.

Allerdings ist die thermische Belastbarkeit der erwähnten bekannten Meßwertaufnehmer recht begrenzt, so daß diese nur bis ca. 80° C verwendet werden können. Die Ursache dafür liegt in der Herkunft des Piezoeffektes in den Piezopolymerfolien: polare Molekülgruppen, deren spontane Polarisationen sich im nicht vorbehandelten Polymer wegen statistischer Richtungsverteilung aufheben, werden durch Strekken der Folie in einem starken elektrischen Feld ausgerichtet, wofür eine relativ leichte "Drehbarkeit" der polaren Molekülgruppen Voraussetzung ist. Gerade diese leichte Drehbarkeit bedingt bei Temperaturerhöhung ein rasches Absinken der Gesamtpolarisation. Versuche, die polaren Gruppen zu "verankern", resultieren in optimierten Herstellungsverfahren und können nicht ohne Verlust anderer Eigenschaften noch weiter getrieben werden.

Diese begrenzte thermische Stabilität ist ein prinzipieller Mangel von Piezopolymerfolien, nicht nur von Polyvinyliden-Fluorid. Dabei kann die Materialbeständigkeit als solche recht gut sein.

Außerdem ist es auch schwierig, den mit den leitenden Schichten versehenen piezoelektrischen Film mit den Kunststoffbändern zu verbinden.

Ziel der Erfindung ist es, einen Meßwertaufnehmer der eingangs erwähnten Art vorzuschlagen, der sich durch eine hohe thermische Belastbarkeit auszeichnet.

Erfindungsgemäß wird dies dadurch erreicht, daß das Meßelement aus einer gegen Hitze widerstandsfähigen, flexiblen Tragschichte, z.B. einer flexiblen Metallfolie, wie einer Cu-Be-Folie, oder einer zumindest einseitig metallisierten Kunststoff-Folie besteht, wobei auf der Metalloberfläche der Tragschicht ein gegen Hitze bis mindestens 80°C widerstandsfähigen kristalliner, piezoelektrischer Film z.B. Wurzite, Sphalerite u.s.w. vollflächig aufgebracht ist und auf dem piezoelektrischen Film eine als zweite Elektrode dienender elektrisch Leitender Film, z.B. ein aufgedampfter metallischer Film, aufgebracht ist. Durch diese Maßnahmen ist es möglich, eine hohe thermische Beständigkeit zu erzielen, wobei durch die Verwendung dünner metallischer Folien oder metallisierter Kunststoff-Folien, auf denen dünne piezoelektrische Substratschichten aufgebracht werden, die Biegsamkeit des Meßwertaufnehmers gewährleistet wird, sodaß diese einfach z.B. auf Rohre aufgeklemmt werden können. Diese flexiblen Substrate Schichten können dabei nach der geünschten thermischen Beständigkeit ausgewählt werden, wobei die gemäß der Erfindung vorgesehenen Substrate aufgrund ihrer elektrischen Leitfähigkeit gleichzeitig als Elektroden dienen.

In diesem Zusammenhang kann nach einem weiteren Merkmal der Erfindung vorgesehen sein, die erfindungsgemäßen Meßwertaufnehmer in der Weise herzustellen, daß das auf eine flexible Metallfolie, z.B. eine Cu-Be-Folie, oder auf die Metalloberfläche einer zumindest einseitig metallisierten Kunststoff-Folie direkt ein kristalliner piezoelektrischer Film, z.B. Wurzite, Sphalerite, u.s.w. durch Zerstäuben aufgetragen wird, und daß auf den piezoelektrischen Film als zweite Elektrode eine elektrisch leitende Struktur, z.B. ein metallischer Film, aufgebracht, z.B. aufgedampft, wird. Auf diese Weise ist es möglich, sehr dünne Schichten auf dem flexiblen Film aufzubringen. Auf diese Weise ergibt sich eine, verglichen mit der Herstellung der Meßwertaufnehmer gemäß der AT-PS 375 466 wesentlich einfachere Herstellung.

Durch die DE-AS 28 32 714 wurde bereits vorgeschlagen, kristalline piezoelektrische Filme auf Metalle, Glas, Keramik, Einkristalle, Harz oder Gummi aufzubringen. Dabei werden die Filme aber stets auf massive Blöcke des Substratmaterials aufgebracht, so daß durch diese bekannten Maßnahmen lediglich starre, keinesfalls aber flexible Meßwertaufnehmer erzielt werden könnten. Bei solchen starren Meßwertaufnehmern ergeben sich bei der Anwendung, verglichen mit flexiblen Meßwertaufnehmern größere Probleme im Hinblick auf die Konstruktion entsprechender Befestigungseinrichtungen zur Fixierung der Meßwertaufnehmer an den zu überwachenden Bauteilen.

Nach einem weiteren Merkmal der Erfindung kann vorgesehen sein, daß die zweite Elektrode gleichzeitig bzw. im gleichen Arbeitsgang mit der Aufbringung des piezoelektrischen Films auf die flexible Metallfolie oder auf die Metalloberfläche einer zumindest einseitig metallisierten Kunststoff-Folie auf den piezoelektrischen Film aufgebracht wird, wodurch sich der Herstellungsvorgang sehr einfach gestalten läßt.

Als Materialien für kristalline piezoelektrische Filme gemäß der Erfindung eignen sich solche, die sich in dünnen Filmen, z.B. durch Aufdampfen, orientierte Kristallabscheidung (=Epitaxie) Molekülstrahlepitaxie, Ionenstrahl-Epitaxie, Ionenimplantation, CVD (Chemical Vapour Deposition), Zerstäubungsverfahren (cathode sputtering) aufbringen lassen und sich gleichzeitig durch eine hohe thermische Belastbarkeit auszeichnen. Dies sind vor allem Kristalle der Wurzite-Gruppe. In Reihung nach größe des Piezokoeffizienten $d_{33}$ sind zu nennen: ZnO, CeS, CdSe, -ZnS, AIN, BeO. Die höchste elektrishe Isolationsfähigkeit besitzen dabei ZnO und AIN. Dies sind zugleich jene Materialien, bei denen beim Herstellungsprozeß die c-Achsen-Orientierung am leichtesten zu erreichen ist. Weitere Beispiele sind die Kristalle $Bi_{12}GeO_{20}$ und $Bi_{12}SiO_{20}$.

Die Erfindung wird nun anhand der Zeichnung näher erläutert. Es Zeigen

Figur 1 eine bekannten Meßwertaufnehmer und
Figur 2 und 3 Ausführungsformen eines erfindungsgemäßen Meßwertaufnehmers.

Strichliert sind metallische Bauteile, punktiert Substrate und strichliert und punktiert polymere Materialien angedeutet.

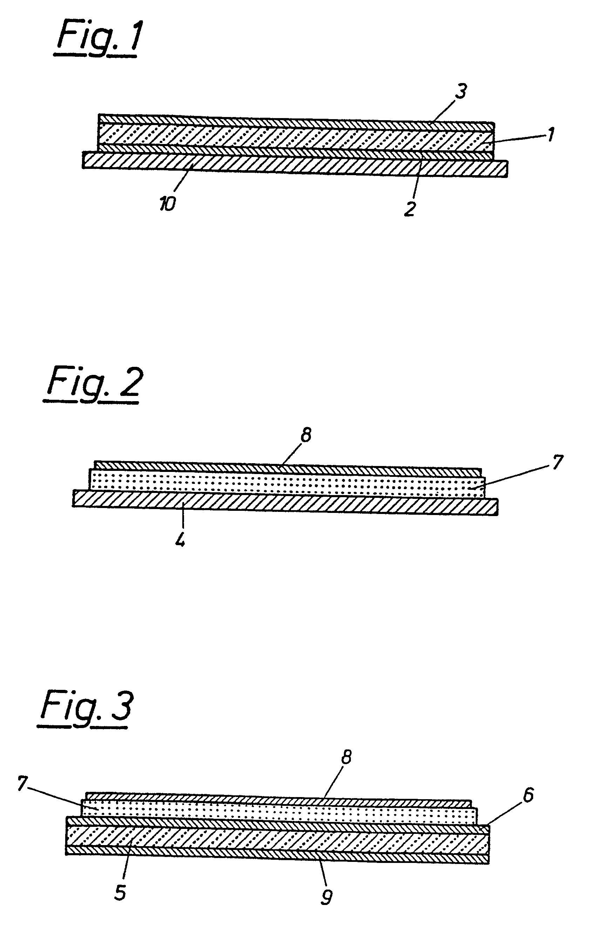

Figur 1 zeigt einen bekannten Meßwertaufnehmer, der von einer piezoelektrischen Polymer-Folie 1 gebildet ist, auf deren beiden Seiten elektrisch leitende Kontaktschichten 2, 3 als Kontakte aufgedampft sind, wobei die kontaktierte Polymer-Folie 1 mit einer metallischen Trägerfolie 10 verklebt ist.

Figur 2 zeigt einen erfindungsgemäßen Meßwertaufnehmer. Auf eine flexible Metallfolie 4, z.B. aus Cu-Be, ist eine dünnere Schicht piezoelektrischen Materials 7 aufgebracht, auf welche Schicht eine zweite Elektrode 8, z.B. aufgedampf oder durch reaktive Kathodenzerstäubung, aufgebracht ist.

Figur 3 zeigt einen erfindungsgemäßen Meßwertaufnehmer, bei dem das piezoelektrische Material 7 auf die Metallschicht 6 einer metallisierten Kunststoff-Folie 5 aufgebracht ist. Mit einer zweiten Elektrode 8 ist das Material 7 abgedeckt. Die Kunststoff-Folie 5 kann auch beidseitig metallisiert sein bzw. eine weitere Metallschicht 9 aufweisen.

Bei den Ausführungsformen nach Fig. 2 und 3 ist das piezoelektrische Material 7 direkt auf die Metallfolie 4 bzw. die Metallschicht 6 aufgebracht und mit dieser fest und haltbar verbunden. Wird gleichzeitig noch die zweite Elektrode 8 auf das Material 7 aufgebracht, z.B. in Form eines metallischer Filmes aufgedampf, wird auch die Herstellungszeit weiter verkürzt.

Solche erfindungsgemäßen Meßwertaufnehmer können z.B. auf ein zu überwachendes Rohr, z.B die Einspritzleitung eines Dieselmotors durch Umwickeln des Rohres mit dem Meßwertaufnehmer aufgebracht werden. Dabei kann eine elektrisch isolierende Kunststoff-Folie zwischen das Rohr und den Meßwertaufnehmer zwischengelegt werden. Die Befestigung des Meßwertaufnehmers kann dabei z.B. mittels einer Klammer erfolgen, deren äußere Anlageflächen mehr als die Hälfte des Rohres umspannt, wie dies in Figur 6 und 7 der AT-PS 375 466 dargestellt ist, wobei diese Klammer im aufgeklemmten Zustand durch das Rohr und den Meßwertaufnehmer leicht aufgeweitet ist und dadurch den Meßwertaufnehmer unter Vorspannung hält, Die Kontaktierung des Meßwertaufnehmers kann bei Verwendung einer Metallfolie als flexibles Substrat direkt an diesem erfolgen.

Bei Verwendung einer metallisierten Kunststoff-Folie als Substrat kann dagegen vorgesehen sein, daß die Kontaktierung die Kunststoff-Folie durchsetzt.

Weiters kann ein erfindungsgemäßer Meßwertaufnehmer auch einfach mit einem Kabelbinder auf einem Rohr fixiert werden, wobei ebenfalls eine isolierende Kunststoff-Folie zwischengelegt werden kann, um eine elektrisch leitende Verbindung zwischen dem Rohr und dem Meßwertaufnehmer oder diesem und dem Kabelbinder zu vermeiden.

## Patentansprüche

1. Flexibler Meßwertaufnehmer mit einem Meßelement zur Messung mechanischer Größer an Hohlkörpern, insbesondere des Druckverlaufes in Rohren, welches Meßelement eine flexiblen piezoelektrischen Film beinhaltet, wobei die gegenüberliegenden Oberflächen des Meßelementes mit elektrisch leitenden Kontaktflächen eine feste Verbindung bilden und über Leitungen mit einer Anzeige- und Auswerteeinrichtung verbindbar sind, **dadurch gekennzeichnet,** daß das Meßelement aus einer gegen Hitze widerstandsfähigen, flexiblen Tragschicht, z.B. einer flexiblen Metallfolie (4), wie einer Cu-Be-Folie, oder einer zumindest einseitig metallisierten Kunststoff-Folie (5) besteht, wobei auf der Metalloberfläche der Tragschicht ein gegen Hitze bis mindestens 80°C widerstandfähiger kristalliner, piezoelektrischer Film z.B Wurzite, Sphalerite u.s.w. vollflächig aufgebracht ist und auf dem kristallinen piezoelektrischen Film (7) eine als zweite Elektrode (8) dienender elektrisch leitender Film, z.B. ein aufgedampfter metallischer Film, aufgebracht ist.

2. Verfahren zur Herstellung eines flexiblen Meßwertaufnehmers nach Anspruch 1, dadurch gekennzeichnet, daß auf eine flexible Metallfolie (4), z.B. eine Cu-Be-Folie, oder auf die Metalloberfläche einer zumindest einseitig metallisierten Kunststoff-Folie (5) direkt ein kristalliner piezoelektrischer Film (7), z.B. Wurzite, Sphalerite, u.s.w. durch Zestäuben aufgetragen wird, und daß auf den kristallinen piezoelektrischen Film als zweite Elektrode (8) eine elektrische leitende Struktur z.B. ein metallischer Film, aufgebracht, z.B. aufgedampft wird.

3. Verfahren nach Anspruch 2, dadurch gekennzeichnet, daß die zweite Elektrode (8) gleichzeitig bzw. im gleichen Arbeitsgang mit der Aufbringung des kristallinen piezoelektrischen Films (7) auf die flexible Metallfolie (4) oder auf die Metalloberfläche einer zumindest einseitig metallisierten Kunststoff-Folie (5) auf den kristallinen piezoelektrischen Film aufgebracht wird.

## Revendications

1. Transducteur flexible avec un élément de mesure pour mesurer des grandeurs mécaniques dans des corps creux, notamment l'évolution de la pression dans des tubes, cet élément de mesure comprenant un film piézo-électrique flexible, tandis que les surfaces opposées de l'élément de mesure forment avec des surfaces de contact électriquement conductrices, une liaison fixe et sont susceptibles d'être raccordées par des conducteurs à un dispositif d'affichage et d'exploitation, transducteur flexible caractérisé en ce que l'élément de mesure est constitué par une couche flexible de support, résistant à la chaleur, par exemple une feuille métallique flexible (4), telle qu'une feuille Cu-Be, ou bien une feuille de matière plastique (5) métallisée sur au moins une face, tandis que sur toute la surface métallique de la couche de support est rapporté un film piézo-électrique cristallin, résistant à la chaleur jusqu'à au moins 80°C, par exemple de la wurzite, de la sphalérite, etc..., et que sur ce film piézo-électrique cristallin (7) est rapporté un film électriquement conducteur, par exemple un film métallique déposé par condensation de vapeur, et qui joue le rôle de seconde électrode (8).

2. Procédé pour la fabrication d'un transducteur flexible selon la revendication 1, caractérisé en ce que, sur une feuille métallique flexible (4), par exemple une feuille Cu-Be, ou bien sur la surface métallique d'une feuille de matière plastique (5) métallisée sur au moins une face, on rapporte directement par pulvérisation un film piézo-électrique cristallin (7), par exemple de la wurzite, de la sphalérite, etc..., et en ce que sur ce film piézo-électrique cristallin, on rapporte, en tant que seconde électrode (8), une structure électriquement conductrice, par exemple un film métallique déposé par exemple par condensation de vapeur.

3. Procédé selon la revendication 2, caractérisé en ce que la seconde électrode (8) est rapportée sur le film piézo-électrique cristallin (7) en même temps ou dans le même processus opératoire que le dépôt du film piézo-électrique cristallin (7) sur la feuille métallique flexible (4) ou sur la surface métallique d'une feuille de matière plastique (5) métallisée sur au moins une face.

## Claims

1. Flexible transducer with a sensor element for measuring mechanical quantities in hollow bodies, i.e. above all pressures in pipes, which sensor element comprises a flexible piezoelectric film, the opposite surfaces of the sensor element being bonded to electrically conductive contact layers and being connected via leads to a display and evaluation unit, **wherein** the said sensor element is made of heat-resistant flexible supporting material, for instance flexible metal foil (4), such as Cu-Be foil, or of some plastic foil (5) one of whose sides at least is metallized, the entire surface of the metallic side of the supporting layer being coated with a crystalline, piezoelectric film (7) of wurtzite or sphalerite, etc, which film (7) is heat-resistant up to a minimum of 80°C, said crystalline, piezoelectric film (7) in turn being provided with an electrically conductive film serving as a second electrode (8), for instance, a metal film applied by evaporation.

2. Method of manufacturing a flexible transducer according to claim 1, wherein a crystalline, piezoelectric film (7) of wurtzite or sphalerite, etc, for example, is directly sprayed onto a flexible metal foil (4), such as Cu-Be foil, or onto the metal surface of a plastic foil (5) one of whose sides at least has been metallized, and wherein an electrically conductive coating, such as a metal film, is applied on the crystalline, piezoelectric film as a second electrode (8), for example, by evaporation.

3. Method according to claim 2, wherein the second electrode (8) is applied to the crystalline, piezoelectric film (7) at the same time or during the same operating cycle as the crystalline, piezoelectric film (7) is applied to the flexible metal foil (4) or to the metal surface of a plastic foil (5) metallized at least on one of its sides.

_Fig.1_

_Fig.2_

_Fig.3_